# EUROPEAN PATENT APPLICATION

(11) **EP 4 742 546 A1**
(43) Date of publication of application: **13.05.2026**
(21) Application number: 24852185.8
(22) Date of filing: 30.07.2024
(51) Int. Cl.: H04B 1/04, H03F 1/02, H04W 84/06

(54) **ELECTRONIC DEVICE FOR CONTROLLING SWITCH ELECTRICALLY CONNECTED TO ANTENNA, AND OPERATION METHOD THEREOF**

(30) Priority: 07.08.2023 KR 20230103015; 19.09.2023 KR 20230124481
(71) Applicant: Samsung Electronics Co., Ltd., Suwon-si, Gyeonggi-do 16677 (KR)
(72) Inventor: KIM, Cheonshik, Suwon-si, Gyeonggi-do 16677 (KR); SEO, Hyunmin, Suwon-si, Gyeonggi-do 16677 (KR); KIM, Seunghwan, Suwon-si, Gyeonggi-do 16677 (KR); LEE, Dongsub, Suwon-si, Gyeonggi-do 16677 (KR); LEE, Hyungmin, Suwon-si, Gyeonggi-do 16677 (KR); JEON, Minhwan, Suwon-si, Gyeonggi-do 16677 (KR)
(74) Representative: HGF
(86) International application number: PCT/KR2024/011188
(87) International publication number: WO 2025/033831

(57) **Abstract**

This electronic device comprises: a power amplifier (PA) (830) for amplifying a RF signal to be transmitted to a satellite base station; a first power amplifier power management integrated circuit (PA PMIC) (811) for supplying power onto the PA; a first switch (821) for connecting one among an output port of the first PA PMIC and an input port of the PA to the first PA PMIC; and a communication processor (610). The communication processor may: control the first switch so as to connect the output port of the first PA PMIC to the first PA PMIC; control the first PA PMIC so as to measure an output voltage of the first PA PMIC; control the first switch so as to connect the input port of the PA to the first PA PMIC; control the first PA PMIC so as to measure a supply voltage of the PA; determine the difference value between the output voltage of the first PA PMIC and the supply voltage of the PA; and adjust the output voltage of the first PA PMIC on the basis of the determined difference value.

## Description

### [Technical Field]

Various embodiments of the present document relate to an electronic device and a method for operating an electronic device, and more particularly, to a technology for controlling a switch electrically connected to an antenna.

### [Background Art]

In order to meet the demand for wireless data traffic since the 4th generation (4G) communication system came to the market, there are ongoing efforts to develop enhanced 5G communication systems or pre-5G communication systems. For the reasons, the 5G communication system or pre-5G communication system is called the beyond 4G network communication system or post long-term evolution (LTE) system. To achieve high data rates, the 5G communication systems are being considered for implementation not only in bands (bands below 6 GHz) used by LTE, but also in ultrahigh frequency (mmWave) bands (e.g., such as bands above 6 GHz). In the 5G communication systems, beamforming, massive multiple input multiple output (MIMO), full dimensional MIMO (FD-MIMO), an array antenna, analogue beam-forming, and large scale antenna technologies are being discussed.

The above-described information may be provided as related art for the purpose of assisting in understanding the present disclosure. No claim or determination is made as to whether any of the above-described contents is applicable as prior art related to the present disclosure.

### [Disclosure of Invention]

### [Technical Problem]

Satellite communications may require relatively high transmit power (e.g., about 36 dBm). Because satellite communications use relatively high level (e.g., 36dBm) of transmit power (TX power), even with a relatively small DC resistance (DCR) component on the power wiring, a relatively large voltage drop may occur. In a situation where cellular communication systems and satellite communication systems with the same resistance are compared, cellular communication systems use relatively low level (e.g., 23 to 26dBm) of transmit power (TX power), which results in a relatively lower magnitude of flowing current. As a result, a voltage drop may not occur relatively significantly. Satellite communication systems consume relatively large currents (e.g., 2 A) during transmission compared to cellular communication systems, so a voltage drop may occur relatively significantly.

The electronic device according to a comparative embodiment has limitations in that the voltage drop occur in a power amplifier (PA), resulting in signal distortion.

An electronic device includes: a power amplifier (PA) 830 amplifying a RF signal to be transmitted to a satellite base station; a first power amplifier power management integrated circuit (PA PMIC) 811 supplying power to the power amplifier (PA); a first switch 821 connecting one of an output port of the first PA PMIC and an input port of the PA to the first PA PMIC; and a communication processor 610, wherein the communication processor may control the first switch to connect the output port of the first PA PMIC to the first PA PMIC, control the first PA PMIC to measure an output voltage of the first PA PMIC, control the first switch to connect the input port of the PA to the first PA PMIC, control the first PA PMIC to measure a supply voltage of the PA, determine a difference value between the output voltage of the first PA PMIC and the supply voltage of the PA, and adjust the output voltage of the first PA PMIC based on the determined difference value.

A method for operating an electronic device may include: controlling a first switch to connect an output port of a first PA PMIC to the first PA PMIC; controlling the first PA PMIC to measure the output voltage of the first PA PMIC; controlling the first switch to connect an input port of the PA to the first PA PMIC; controlling the first PA PMIC to measure a supply voltage of the PA; determining a difference value between the output voltage of the first PA PMIC and a supply voltage of the PA; and adjusting the output voltage of the first PA PMIC based on the determined difference value.

An electronic device according to various embodiments of the present document may compensate for a voltage when a voltage drop occurs, thereby preventing distortion of a transmission signal due to the voltage drop.

An electronic device according to various embodiments of the present document may detect a difference between an output of a power amplifier power management IC (PA PMIC) and power supplied to a power amplifier (PA) by adding only a switch, and determine a voltage compensation level.

### [Brief Description of Drawings]

FIG. 1 is a block diagram illustrating an electronic device 101 in a network environment 100 according to various embodiments.
FIG. 2 is a block diagram of an electronic device for supporting legacy network communication and 5G network communication according to various embodiments.
FIG. 3 is a diagram illustrating the electronic device according to one embodiment and a long-distance communication network environment.
FIG. 4 is a diagram for describing connection of the electronic device according to an embodiment.
FIG. 5 is a diagram for describing a non-terrestrial network system 500 according to an embodiment.
FIG. 6 is a block diagram illustrating a configuration of the electronic device according to an embodiment.
FIG. 7A is a block diagram illustrating a configuration of a communication circuit according to a comparative embodiment.
FIG. 7B is a graph illustrating signal distortion that occurs during signal transmission using a communication circuit according to a comparative embodiment.
FIG. 8A illustrates a configuration for describing a switching operation of an electronic device according to an embodiment of the present document.
FIG. 8B illustrates a first embodiment of a switching operation of the electronic device according to an embodiment of the present document.
FIG. 9 illustrates locations of a PMIC and a satellite power amplifier (PA) on the electronic device according to an embodiment.
FIG. 10 is a flowchart illustrating an antenna switching operation of the electronic device according to an embodiment.

### [Mode for the Invention]

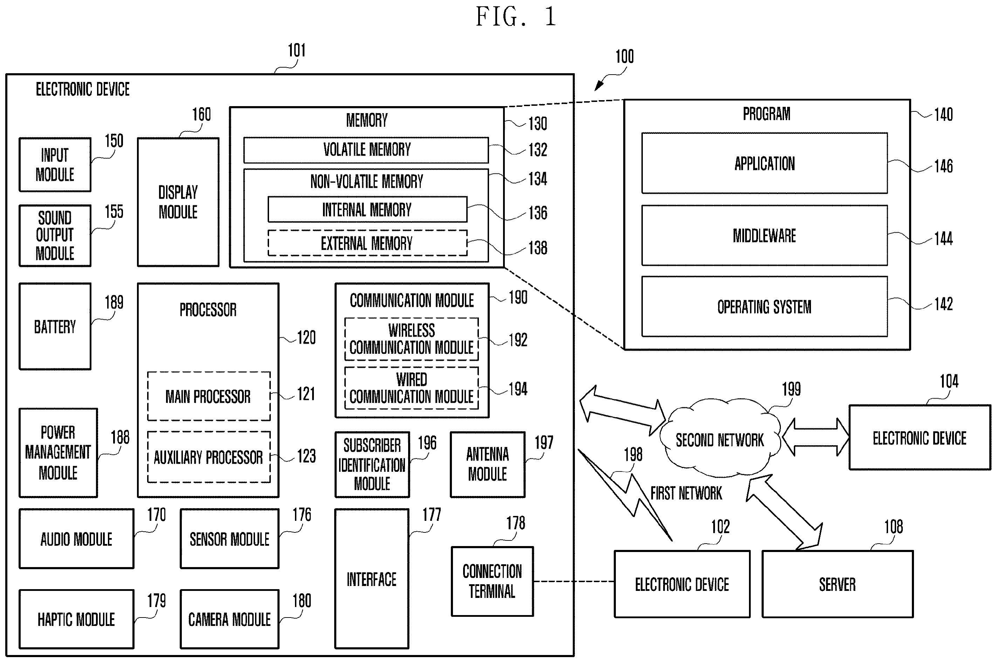

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a _ artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

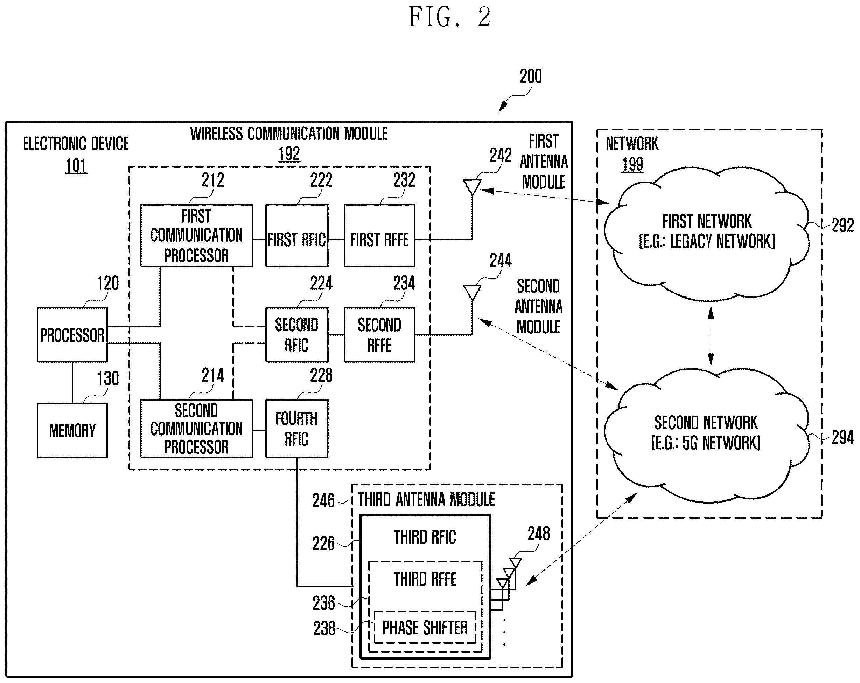

FIG. 2 is a block diagram 200 of an electronic device 101 for supporting legacy network communication and 5G network communication according to various embodiments. Referring to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include a processor 120 and a memory 130. The network 199 may include a first network 292 and a second network 294. According to another embodiment, the electronic device 101 may further include at least one of the components described in FIG. 1, and the network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least a portion of the wireless communication module 192. According to another embodiment, the fourth RFIC 228 may be omitted or included as a portion of the third RFIC 226.

The first communication processor 212 may support establishment of a communication channel in a band to be used for wireless communication with the first network 292, and legacy network communication via the established communication channel. According to various embodiments, the first network may be a legacy network including a second generation (2G), 3G, 4G, or long term evolution (LTE) network. The second communication processor 214 may support establishment of a communication channel corresponding to a designated band (e.g., about 6 GHz to about 60 GHz) among the bands to be used for the wireless communication with the second network 294, and 5G network communication via the established communication channel. According to various embodiments, the second network 294 may be a 5G network defined by the 3GPP. Additionally, according to an embodiment, the first communication processor 212 or the second communication processor 214 may support establishment of a communication channel corresponding to another designated band (e.g., below 6 GHz) among the bands to be used for wireless communication with the second network 294, and the 5G network communication via the established communication channel. According to an embodiment, the first communication processor 212 and the second communication processor 214 may be implemented in a single chip or a single package. According to various embodiments, the first communication processor 212 or the second communication processor 214 may be formed in a single chip or a single package with the processor 120, the auxiliary processor (e.g., the auxiliary processor 123 of FIG. 1), or the communication module (e.g., the communication module 190 of FIG. 1).

Upon transmission, the first RFIC 222 may convert a baseband signal generated by the first communication processor 212 into a radio frequency (RF) signal of about 700 MHz to about 3 GHz used in the first network 292 (e.g., a legacy network). Upon reception, an RF signal may be acquired from the first network 292 (e.g., a legacy network) via an antenna (e.g., the first antenna module 242) and may be preprocessed via an RFFE (e.g., the first RFFE 232). The first RFIC 222 may convert the preprocessed RF signal into a baseband signal so that the preprocessed RF signal may be processed by the first communication processor 212.

Upon transmission, the second RFIC 224 may convert the baseband signal generated by the first communication processor 212 or the second communication processor 214 into an RF signal (hereinafter, a 5G Sub6 RF signal) of a Sub6 band (e.g., about 6 GHz or less) used in the second network 294 (e.g., a 5G network). Upon reception, the 5G Sub6 RF signal may be acquired from the second network 294 (e.g., the 5G network) via the antenna (e.g., the second antenna module 244) and preprocessed via the RFFE (e.g., the second RFFE 234). The second RFIC 224 may convert the preprocessed 5G Sub6 RF signal into the baseband signal so that the preprocessed 5G Sub6 RF signal may be processed by the corresponding communication processor among the first communication processor 212 and the second communication processor 214.

The third RFIC 226 may convert the baseband signal generated by the second communication processor 214 into an RF signal (hereinafter, a 5G Above6 RF signal) of a 5G Above6 band (e.g., about 6 GHz to about 60 GHz) to be used in the second network 294 (e.g., the 5G network). Upon reception, the 5G Above6 RF signal may be acquired from the second network 294 (e.g., the 5G network) via the antenna (e.g., the antenna 248) and preprocessed via the third RFFE 236. The third RFIC 226 may convert the preprocessed 5G Above6 RF signal into the baseband signal so that the preprocessed 5G Above6 RF signal may be processed by the second communication processor 214. According to an embodiment, the third RFFE 236 may be formed as a portion of the third RFIC 226.

According to an embodiment, the electronic device 101 may include the fourth RFIC 228 separately from or at least as a portion of the third RFIC 226. In this case, the fourth RFIC 228 may convert the baseband signal generated by the second communication processor 214 into an RF signal (hereinafter, an IF signal) of an intermediate frequency band (e.g., about 9 GHz to about 11 GHz) and then transmit the IF signal to the third RFIC 226. The third RFIC 226 may convert the IF signal into the 5G Above6 RF signal. Upon reception, the 5G Above6 RF signal may be received from the second network 294 (e.g., the 5G network) via the antenna (e.g., the antenna 248) and converted into the IF signal by the third RFIC 226. The fourth RFIC 228 may convert the IF signal into the baseband signal so that the IF signal may be processed by the second communication processor 214.

According to an embodiment, the first RFIC 222 and the second RFIC 224 may be implemented as at least a portion of a single chip or a single package. According to an embodiment, the first RFFE 232 and the second RFFE 234 may be implemented as at least a portion of a single chip or a single package. According to an embodiment, at least one antenna module of the first antenna module 242 or the second antenna module 244 may be omitted or coupled to with another antenna module to process RF signals of corresponding multiple bands.

According to an embodiment, the third RFIC 226 and the antenna 248 may be disposed on the same substrate to form the third antenna module 246. For example, the wireless communication module 192 or the processor 120 may be disposed on a first substrate (e.g., a main PCB). In this case, the third RFIC 226 may be disposed on a partial region (e.g., lower surface), and the antenna 248 may be disposed on another partial region (e.g., upper surface) of a second substrate (e.g., sub PCB) separate from the first substrate, thereby forming the third antenna module 246. By disposing the third RFIC 226 and the antenna 248 on the same substrate, it is possible to reduce a length of a transmission line between the third RFIC 226 and the antenna 248. This may reduce, for example, a loss (e.g., attenuation) of signals in a high-frequency band (about 6 GHz to 60 GHz) used in the 5G network communication due to the transmission line. As a result, the electronic device 101 may improve the quality or speed of communication with the second network 294 (e.g., the 5G network).

According to an embodiment, the antenna 248 may be formed as an antenna array including a plurality of antenna elements that may be used for beamforming. In this case, the third RFIC 226 may include, as a part of the third RFFE 236, for example, a plurality of phase shifters 238 corresponding to a plurality of antenna elements. Upon transmission, each of the plurality of phase shifters 238 may shift a phase of the 5G Above6 RF signal to be transmitted to the outside (e.g., a base station of the 5G network) of the electronic device 101 via the corresponding antenna element. Upon reception, each of the plurality of phase shifters 238 may shift the phase of the 5G Above6 RF signal received from the outside via the corresponding antenna element to the same or substantially the same phase. This enables the transmission or reception via the beamforming between the electronic device 101 and the outside.

The second network 294 (e.g., the 5G network) may operate independently (e.g., stand-alone (SA)) from the first network 292 (e.g., the legacy network) or operate while connected (e.g., non-stand alone (NSA)) to the first network 292 (e.g., the legacy network). For example, the 5G network may only have an access network (e.g., a 5G radio access network (RAN) or next generation RAN (NG RAN)) and may not include core network (e.g., next generation core (NGC)). In this case, the electronic device 101 may access the access network of the 5G network and then access an external network (e.g., the Internet) under the control of the core network (e.g., evolved packed core (EPC)) of the legacy network. Protocol information (e.g., LTE protocol information) for communicating with the legacy network or protocol information (e.g., new radio (NR) protocol information) for communicating with the 5G network may be stored in the memory 130 and accessed by other components (e.g., the processor 120, the first communication processor 212, or the second communication processor 214).

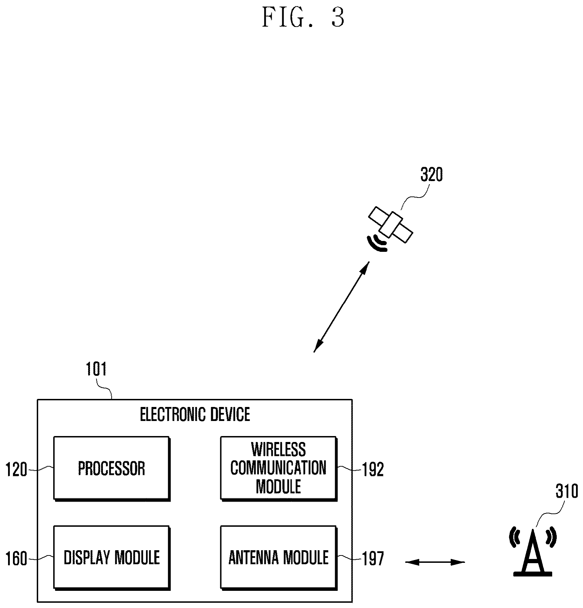

FIG. 3 is a diagram illustrating the electronic device according to one embodiment and a long-distance communication network environment.

The electronic device 101 may transmit and/or receive data via a terrestrial network and/or a non-terrestrial network. The electronic device 101 may be identical to the configuration of the electronic device illustrated in FIG. 1 or may include the configuration of the electronic device illustrated in FIG. 1.

The terrestrial network may refer to a network capable of providing data communication via the terrestrial wireless communication device 310. For example, the terrestrial wireless communication device 310 may include a base station located on the ground (e.g., fixed on the ground). The terrestrial wireless communication device 310 may support at least one of various communication schemes supported by the electronic device 101. For example, the terrestrial wireless communication device 310 may include an eNodeB or a gNodeB, but the type thereof is not limited.

The non-terrestrial network may refer to a network capable of providing data communication via at least one non-terrestrial wireless communication device 320. For example, the non-terrestrial wireless communication device 320 may include at least one of various communication devices, such as a base station or a repeater, that are not located on the ground. For example, the non-terrestrial wireless communication device 320 may include a satellite and/or an unmanned aerial vehicle, but the type thereof is not limited. For example, the satellite may include a low-earth orbit (LEO) satellite, a medium-earth orbit (MEO) satellite, a geostationary earth orbit (GEO) satellite, and/or a high elliptical orbit (HEO) satellite. For example, the satellite may include a mobile satellite and/or a geostationary satellite.

The non-terrestrial wireless communication device 320 may support at least one of various wireless communication schemes. For example, the non-terrestrial wireless communication device 320 may support a non-terrestrial network (NR NTN) defined by a 3rd generation partnership project (3GPP). Alternatively, the non-terrestrial wireless communication device 320 may support at least one of the communication schemes based on various communication standards, such as LTE, global system for mobile communications (GSM), and code-division multiple access (CDMA), but the type thereof is not limited.

The terrestrial network and the non-terrestrial network may be independent networks of each other. Alternatively, the terrestrial network and the non-terrestrial network may be included in at least one network (e.g., a network provided by the same operator) associated with each other.

The electronic device 101 may perform wireless communication via the non-terrestrial network when the communication with the terrestrial network is unavailable or not smooth. Alternatively, in some cases, the electronic device 101 may also perform the wireless communication via the non-terrestrial network regardless of the communication state with the terrestrial network.

According to an embodiment, the electronic device 101 may include the processor 120, the display module 160 (e.g., a display), the wireless communication module 192 (e.g., a communication circuit), and/or the antenna module 197. For example, the processor 120 may be operatively, functionally, and/or electrically connected to the display module 160, the wireless communication module 192, and/or the antenna module 197.

The processor 120 may, for example, execute instructions (e.g., the program 140 of FIG. 1) at least temporarily stored in a memory (e.g., the memory 130 of FIG. 1) to control at least one other component (e.g., hardware or software components) of the electronic device 101 connected to the processor 120, and perform various data processing or calculations. According to an embodiment, the processor 120 may control overall operations related to the terrestrial network communication and/or the non-terrestrial network communication. For example, the processor 120 may include the communication processor (e.g., the auxiliary processor 123 of FIG. 1) related to the terrestrial network communication and/or the non-terrestrial network communication.

The display module 160 may visually provide information to an outside (e.g., a user) of the electronic device 101.

According to an embodiment, the display module 160 may display a UI indicating the information related to the terrestrial network and/or the non-terrestrial network. For example, the UI indicating the information related to the terrestrial network and/or the non-terrestrial network may include at least one of UIs indicating information that is related to a type of network (e.g., cellular communications (3G, 4G, 5G), short-range communication (e.g., BT, WIFI, satellite communication), a type of network service provider (e.g., satellite communication service provider (e.g., Iridium), emergency service provider (ESP), a network signal strength (e.g., signal strength bars, RSSI, RSRP), an orientation (e.g., orientation, elevation angle, azimuth angle) of a communication device (satellite) included in the network, presence information, and/or a network communication state (e.g., idle, transmit, receive).

According to an embodiment, the display module 160 may display a UI indicating a service related to the terrestrial network and/or the non-terrestrial network.

According to an embodiment, the service related to the terrestrial network and/or the non-terrestrial network may include, for example, at least one of an emergency message transmission service, a messaging service, a voice call, a video call, a data communication service, a location-related service, and/or an indicator-related service.

According to an embodiment, the emergency message transmission service may include, but is not limited to, at least one of: a service providing SOS service state information (e.g., indicating SOS service availability), a service providing government office information, a service providing emergency contact information, a service providing common phrases to minimize user text input, and a service (e.g., a service providing options for accident type, injured area, and medical information (e.g., age, gender, disease information, medication information)) using a questionnaires scheme to quickly transmit emergency situations.

According to an embodiment, the messaging service may include, but is not limited to, at least one of a small message service (SMS), a multimedia messaging service (MMS), and a rich communication suite (RCS) message.

According to an embodiment, the data communication service may include services via various applications (e.g., a web browser) that provide data communication.

According to an embodiment, the location-related service may include, but is not limited to, at least one of: longitude/latitude coordinates, location-related map information of the non-terrestrial communication device 320, navigation, and street view.

According to an embodiment, the UI examples are not limited to the examples mentioned and may also be provided via other output devices (e.g., the sound output module 155 of FIG. 1).

According to an embodiment, the wireless communication module 192 may support various types of wireless communication bands supported by the electronic device 101. For example, the wireless communication bands supported by the electronic device 101 may include, but are not limited to, short-range wireless communication bands (e.g., BT, Wifi), terrestrial network (e.g., cellular network) communication bands, and/or non-terrestrial network bands.

According to an embodiment, the electronic device 101 may support frequency bands (e.g., n255, 256) associated with the non-terrestrial network wireless communication. The electronic device 101 may perform the non-terrestrial network wireless communication using the frequency bands associated with the non-terrestrial network wireless communication, but is not limited thereto. For example, the electronic device 101 may perform the non-terrestrial network wireless communication using at least a portion of the frequency band associated with the terrestrial network wireless communication.

According to an embodiment, the antenna module 197 may transmit or receive signals or power to or from the outside (e.g., an external electronic device).

According to an embodiment, the electronic device 101 may perform wireless communication with the non-terrestrial network using at least one of the plurality of antennas included in the antenna module 197. The at least one antenna supporting the non-terrestrial wireless communication may include a dedicated antenna and/or a dual-purpose antenna. The dedicated antenna may include an antenna supporting the non-terrestrial network. The dual-purpose antenna may include an antenna supporting both a different type of network and the non-terrestrial network. For example, the electronic device 101 may communicate with at least one satellite (e.g., a GNSS satellite, an emergency message service satellite) using at least one dedicated antenna for the non-terrestrial network. For example, the dual-purpose antenna may include an antenna supporting the short-range communication networks (e.g., Bluetooth networks, Wi-Fi networks) and/or the terrestrial network (e.g., long-term evolution (LTE) network). The electronic device 101 may support the non-terrestrial network using the plurality of antennas among the antennas supporting the terrestrial network.

Hereinafter, in the present disclosure, a satellite is primarily referred to as the non-terrestrial wireless communication device 320. Although the satellite is referred to as providing wireless communication based on a specific radio access technology (RAT) (e.g., LTE) or a specific function (e.g., a base station), this is merely an example and the type thereof is not limited.

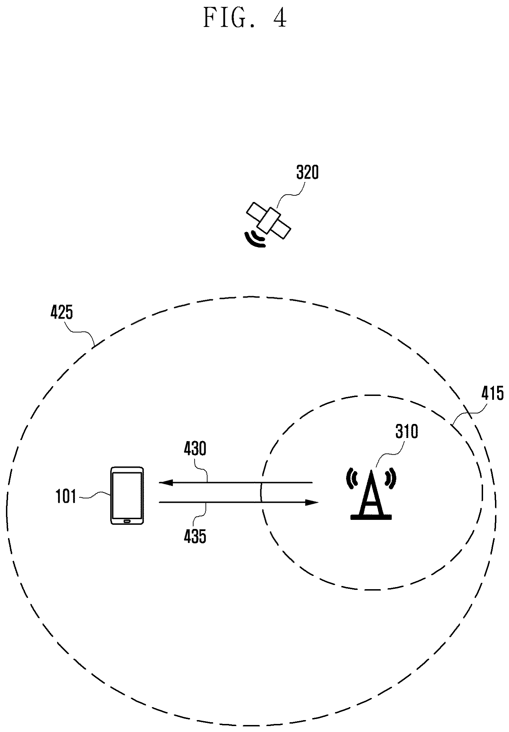

FIG. 4 is a diagram for describing connection of the electronic device according to an embodiment.

According to an embodiment, the electronic device 101 may be located within coverage 415 of the terrestrial wireless communication device 310 (hereinafter, referred to as the terrestrial wireless communication coverage 415) and/or within coverage 425 of the non-terrestrial wireless communication device 320 (hereinafter, referred to as the non-terrestrial wireless communication coverage 425). The non-terrestrial wireless communication coverage 425 may be relatively larger (e.g., 50 times or more) than the terrestrial wireless communication coverage 415. For example, the non-terrestrial wireless communication coverage 425 may cover an area that is not covered by the coverage 415 of the terrestrial wireless communication device 310, allowing the electronic device 101 to perform communication even in areas where terrestrial wireless communication is not supported.

According to an embodiment, the electronic device 101 may perform a cell scan within the terrestrial wireless communication coverage 415 and/or the non-terrestrial wireless communication coverage 425. As a result of performing the cell scan, the electronic device 101 may identify a cell provided by the terrestrial wireless communication device 310 and/or a cell provided by the non-terrestrial wireless communication device 320. When there is a cell that satisfies the cell selection condition, the electronic device 101 may perform at least some of the operations for connecting to a network (e.g., the non-terrestrial network and/or the terrestrial network). Here, the connection to the network may include, but is not limited to, at least some of the preceding operations (e.g., camp on, connection procedure (e.g., random access (RA) procedure)) for registration to the network and/or a registration operation (e.g., attach, registration) to the network. When disconnection from the network is required (e.g., moving to a different network), the electronic device 101 may perform at least some of the disconnection operations. The disconnection from the network may include at least some of detaching from the network, disconnecting from the network, and/or declaring a radio link failure (RLF), but is not limited to the listed operations.

According to an embodiment, the electronic device 101 may perform at least some of the following operations: cell scanning, disconnecting from the network, and/or connecting to the network, depending on movements 430 and 435.

According to an embodiment, when the electronic device 101 is located within the terrestrial communication coverage 415 included in the non-terrestrial wireless communication coverage 425, or when located in a boundary area of the terrestrial communication coverage 415, the electronic device 101 may perform the connection to the terrestrial network and/or the non-terrestrial network based on a policy (e.g., priority policy) of the electronic device 101.

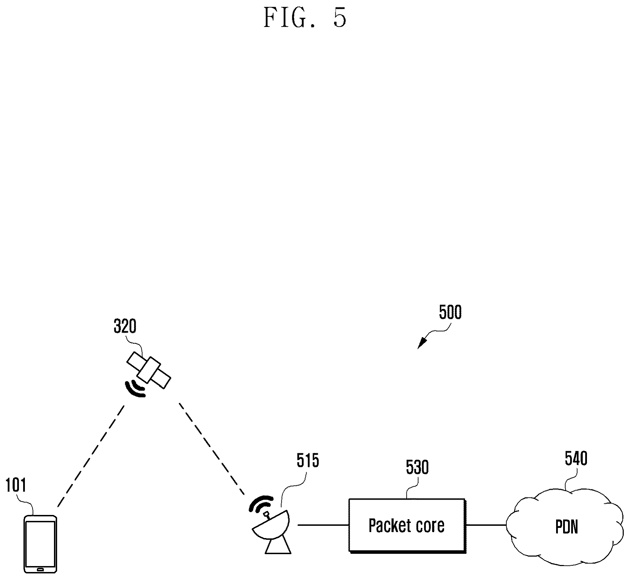

FIG. 5 is a diagram for describing a non-terrestrial network system 500 according to an embodiment.

Referring to FIG. 5, the non-terrestrial network system 500 may include the non-terrestrial wireless communication device 320, a radio unit 515, and a packet core 530.

According to an embodiment, the non-terrestrial network system 500 may be implemented, for example, in a regenerative scheme. When implemented in the regenerative scheme, at least one non-terrestrial wireless communication device 320 may include a base station (e.g., an eNode B). The non-terrestrial network system 500 may be implemented, for example, in a bent-pipe scheme. The bent-pipe scheme may include a passive relay scheme that performs frequency conversion and power amplification on a received signal. When the non-terrestrial network system 500 is implemented in the bent-pipe scheme, at least one non-terrestrial wireless communication device 320 may include a repeater that converts (e.g., amplifies) and transmits a signal. The implementation scheme of the non-terrestrial network system 500 and the role of the non-terrestrial wireless communication device 320 described in FIG. 5 are merely one example, and are not limited thereto.

According to an embodiment, the non-terrestrial wireless communication device 320 may include at least one satellite. The non-terrestrial wireless communication device 320 may communicate with the electronic device 101 using, for example, the terrestrial network (e.g., a cellular network) band and/or the non-terrestrial network band. The terrestrial network band may be, for example, an operating band supported by long term evolution (LTE) and/or new radio (NR), but is not limited thereto. The non-terrestrial network band may include, but is not limited to, bands (e.g., n255 and/or n256 bands) defined by 3GPP.

According to an embodiment, at least one radio unit 515 may receive a signal from the non-terrestrial wireless communication device 320 and transmit the signal to a packet core 530. The radio unit 515 and the non-terrestrial wireless communication device 320 may perform communication using, for example, the non-terrestrial network band. The non-terrestrial network band may be different from the terrestrial network band, but may be configured identically in some cases.

According to an embodiment, at least one packet core 530 may transmit and receive data associated with the electronic device 101 using the radio unit 515. Accordingly, the packet core 530 may process data associated with the electronic device 101 and transmit the data to a packet data network (PDN) 540 (e.g., the Internet). The packet core 530 may include, for example, at least a portion of an evolved packet core (EPC) and/or a 5G core (5GC), but is not limited thereto. The packet core 530 may include a packet core associated with an operator of the non-terrestrial wireless communication device 320 and/or a packet core associated with a mobile network operator (MNO). The packet core 530 may be additionally connected to a public switched telephone network (PSTN) (not shown) to transmit and receive the data associated with the electronic device 101.

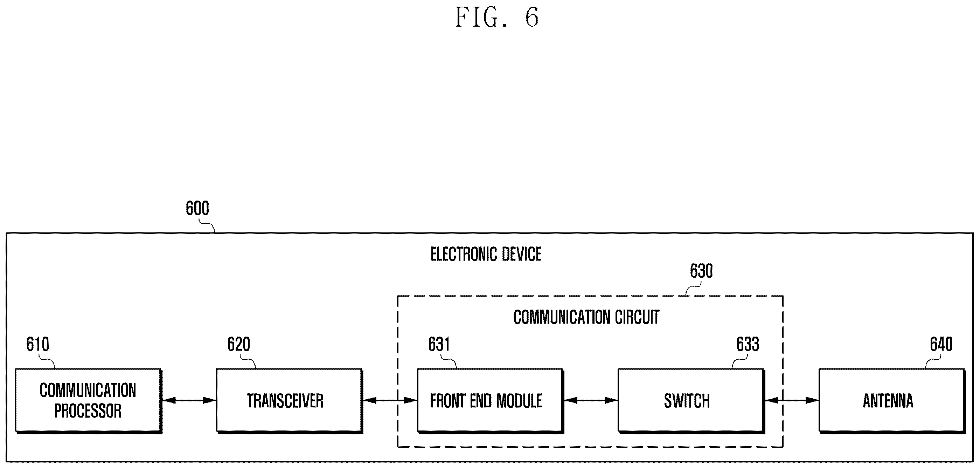

FIG. 6 is a block diagram illustrating a configuration of the electronic device according to an embodiment.

Referring to FIG. 6, an electronic device 600 (e.g., the electronic device 101 of FIG. 1) may include a communication processor (e.g., the first communication processor 212 of FIG. 2 or the second communication processor 214 of FIG. 2) 610, a transceiver (e.g., the first RFIC 222, the second RFIC 224, or the fourth RFIC 228 of FIG. 2) 620, a communication circuit 630, and/or an antenna (e.g., the first antenna module 242, the second antenna module 244, or the third antenna module 246 of FIG. 2) 640.

The communication processor 610 may receive or transmit control data or user data via the short-range wireless communication (e.g., Wi-Fi or Bluetooth) or the cellular wireless communication (e.g., 4th generation mobile communication or 5th generation mobile communication). The communication processor 610 may establish a cellular communication connection with a base station through control data, and transmit data received from an application processor (e.g., the processor 120 of FIG. 1) to the base station through the established cellular communication, or transmit data received from the base station to the application processor 120.

The transceiver 620 may perform various operations of processing the signal received from the communication processor 610. For example, the transceiver 620 may perform a modulation operation on the signal received from the communication processor 610. For example, the transceiver 620 may perform a frequency modulation operation of converting a baseband signal into a radio frequency (RF) signal used for cellular communication. The transceiver 620 may also perform a demodulation operation on a signal received from the outside via the communication circuit 630. For example, the transceiver 620 may perform a frequency demodulation operation of converting the radio frequency (RF) signal into the baseband signal.

The communication circuit 630 may include at least one RF chain that receives an externally radiated signal via the antenna 640 or radiates the signal transmitted by the transceiver 620 via the antenna 640. For example, the RF chain may refer to a signal movement path between the transceiver 620 and the antenna 640. The RF chain may include a front-end module 631 that includes various components (e.g., amplifier, switch, filter) that amplify a signal received via the antenna 640 and/or a signal transmitted by the transceiver 620 and perform an operation of filtering the amplified signal.

The communication circuit 630 may include a switch 633 that electrically connects any one of a plurality of grounds implemented inside the electronic device 600 to the antenna 640.

The communication processor 610 may control the switch 633 in various schemes. When a line (e.g., an inter-process communication (IPC) line) for transmitting the control signal of the switch 633 exists between the communication processor 610 and the switch 633, the communication processor 610 may control the switch 633 by transmitting a control signal of the switch 633 to the switch 633. When a line (e.g., an IPC line) for transmitting the control signal of the switch 633 does not exist between the communication processor 610 and the switch 633, the communication processor 610 may control the switch 633 by transmitting a control signal of the switch 633 to the switch 633 via transceiver 620 or front-end module 631.

In FIG. 6, only one transceiver 620, one switch 633, and one antenna 640 are illustrated for explanation, but the electronic device 600 may include multiple instances of each component.

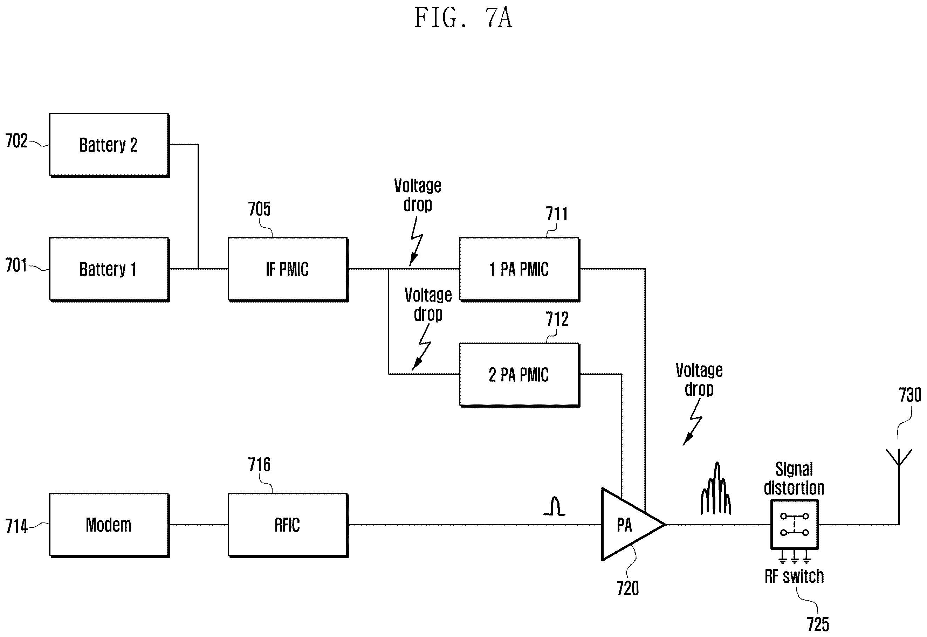

FIG. 7A is a block diagram illustrating a configuration of a communication circuit according to a comparative embodiment.

According to FIG. 7A, the communication circuit according to a comparative embodiment may include a configuration for transmitting and receiving a signal using an antenna 730. The communication circuit according to the comparative embodiment may include a plurality of batteries (e.g., a first battery 701, a second battery 702). The communication circuit according to the comparative embodiment may include an IF PMIC 705. The interface power management IC (IF PMIC) 705 may manage the supply of power provided to various components inside the electronic device. The interface power management IC (IF PMIC) 705 may supply power to hardware components (e.g., a display, a touchscreen, a camera, memory, etc.). The IF PMIC 705 may convert the battery voltage and provide various voltage and current values to supply optimal power to each hardware component.

The communication circuit according to a comparative embodiment may include multiple PA PMICs (a first PA PMIC 711, a second PA PMIC 712). The power amplifier power management IC (PA PMIC) may supply or transmit power using a power amplifier (PA) 720 which is a main component. The communication circuit according to the comparative embodiment may include a modem 714 (e.g., the communication processor 610 of FIG. 6) and an RFIC 716 for satellite communication. The communication circuit according to the comparative embodiment may include an RF switch 725 that selectively transmits signals in various frequency bands and blocks signals in other unselected frequency bands. The communication circuit according to the comparative embodiment may prevent interference between signals and improve transmission quality by using the RF switch 725. That is, in the satellite communication, the RF switch 725 may play a role in improving the transmission quality by enabling signal switching and selective transmission.

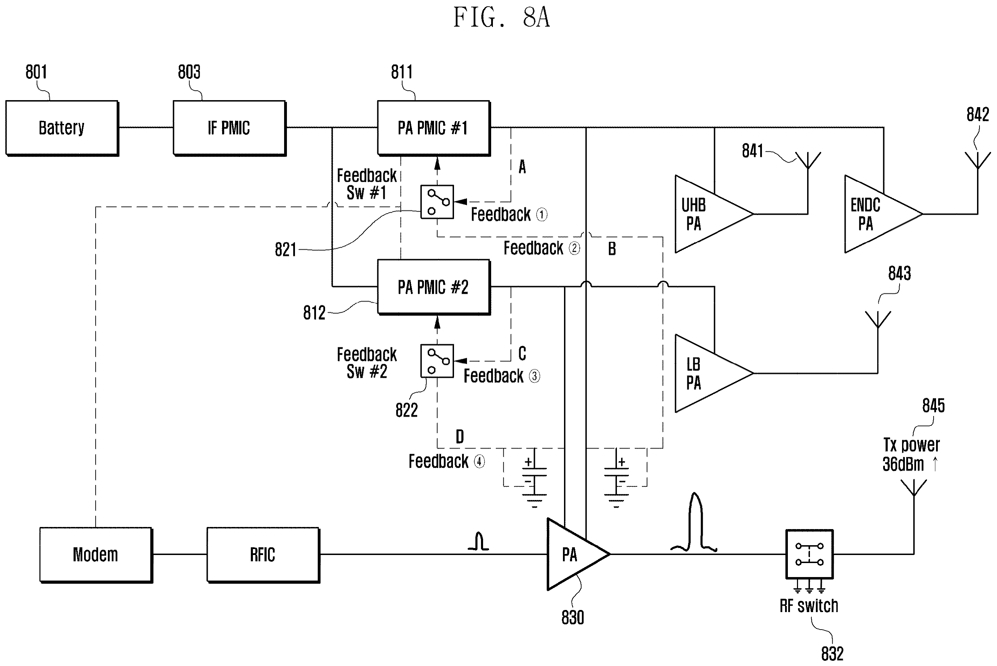

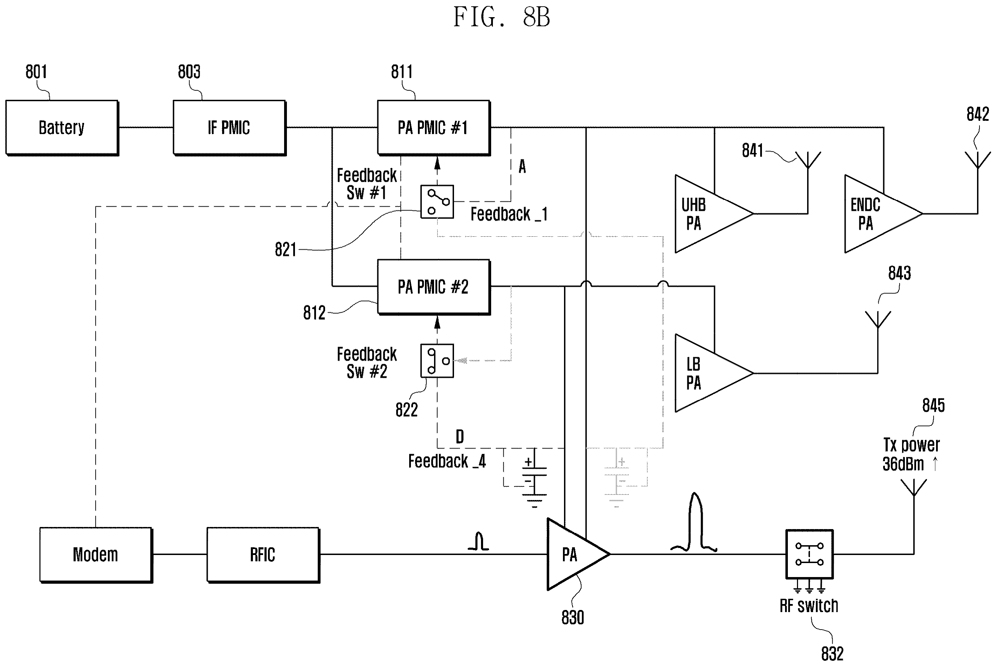

The configurations described in FIG. 7A may also be illustrated in FIGS. 8A and 8B, which describe the electronic device according to the present document, and their basic roles are the same as those described in FIG. 7A.

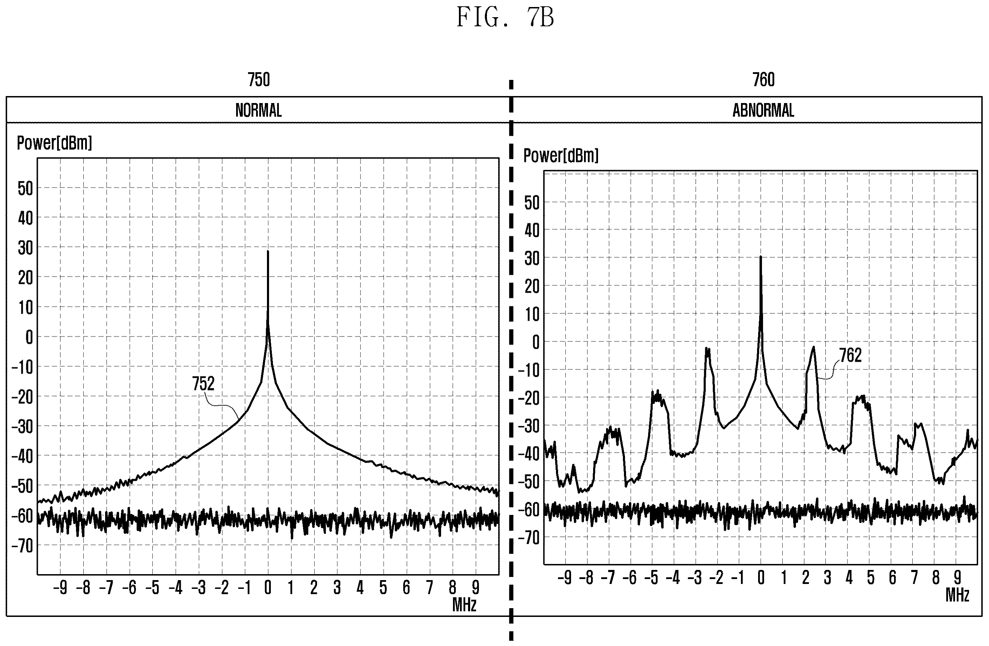

FIG. 7B is a graph illustrating signal distortion that occurs during signal transmission using a communication circuit according to a comparative embodiment.

The electronic device (e.g., terminal) according to the comparative embodiment may require an effective isotropic radiated power (EIRP) of a certain level (e.g., 29 dBm) or higher to use the satellite communication. To this end, the electronic device uses a Tx power of about 36 dBm or higher. The effective isotropic radiated power (EIRP) may refer to an indicator indicating a power density of a signal generated from a specific antenna. The EIRP may be calculated using the antenna's transmission output and antenna pattern. The antenna pattern may indicate the power density that varies depending on the direction in which the antenna radiates the signal. The EIRP may reflect the efficiency of the antenna and the influence of the propagation environment (e.g., atmosphere, terrain, building, etc.). The EIRP is primarily used in the wireless communication, and may be used to predict a communication distance or a propagation range by measuring the power of the signal generated by the antenna.

To output a relatively high level (e.g., 36 dBm) of transmit power (Tx power) from the power amplifier (PA) 720 used in the satellite communication, a power amplifier (PA) 720 VCC of a certain level (e.g., 5 V) or higher and a power amplifier (PA) 720 current of a certain level (e.g., 2 A) or higher may be required.

The electronic device according to the comparative embodiment may use a power supply device that supports a relatively low level (e.g., 23 to 26 dBm) of transmit power (Tx power). The electronic device according to a comparative embodiment may supply power to the power amplifier (PA) 720 using two or more power supply devices (e.g., PA PMICs) to output a relatively high level (e.g., 36 dBm) of transmit power (Tx power) during the satellite communication.

When using a relatively high output of transmit power (Tx power) in an integrated smartphone terminal structure, a voltage drop phenomenon (Vcc drop) of the power amplifier (PA) 720 may occur under specific conditions (e.g., low battery voltage condition). The low battery voltage condition may vary depending on the configuration. For example, the low voltage condition may be set when the voltage supplied from the battery is 3.7 V or lower. This is merely an example and the low voltage condition is not limited thereto. The voltage drop phenomenon (Vcc drop) may decrease the linearity of the power amplifier (PA) 720. The decrease in the linearity of the power amplifier may cause signal distortion, leading to the deterioration in the quality of the transmitted signal.

The electronic device according to the comparative embodiment uses a relatively high level (e.g., 36 dBm) of transmit power (Tx power) for satellite communication, which may result in a relatively large voltage drop even with a relatively small DC resistance (DCR) component in a power wiring. In the situation where the cellular communication systems and the satellite communication systems with the same resistance are compared, the cellular communication system uses a relatively low level (e.g., 23 to 26 dBm) of transmit power (TX power), which results in a relatively lower magnitude of the flowing current. As a result, the voltage drop may not occur relatively significantly. The satellite communication systems consume relatively large currents (e.g., 2 A) during transmission compared to the cellular communication systems, resulting in the relatively large voltage drop.

Satellite communication services may be used to communicate with an emergency service provider (ESP) in emergencies, such as distress situations in the state in which there is no cellular communication network. To provide the satellite communication services, the electronic device should be able to transmit signals regardless of the battery voltage. However, the electronic device according to the comparative embodiment has limitations in that the voltage drop occurs in the power amplifier (PA) 720, resulting in the signal distortion.

750 in FIG. 7B illustrates a situation where no signal interference occurs. A first graph 752 illustrates the degree to which the signal output from the power amplifier (PA) 720 is distorted in a specific frequency band when attempting to transmit a signal via the antenna 730 in the communication circuit of FIG. 7A. Referring to 750 in FIG. 7B, the first graph 752 may identify that the signal is output without distortion.

In the integrated smartphone terminal structure, when using relatively high output of transmit power (Tx power), the voltage drop (VCC drop) in the power amplifier (PA) 720 may occur under specific conditions, such as a low battery voltage condition. This voltage drop (VCC drop) in the power amplifier (PA) 720 may reduce the linearity of the signal output from the power amplifier (PA) 720, resulting in the signal distortion and the degradation in the transmitted signal quality.

760 in FIG. 7B illustrates the situation where the signal interference occurs due to the reduced linearity of the power amplifier (PA) 720 caused by the voltage drop (VCC drop) in the power amplifier (PA) 720. The second graph 762 may identify that linearity is lacking and the signal quality is unstable.

When the power supplied to the power amplifier (PA) 720 is insufficient, the linearity of the signal output from the power amplifier (PA) 720 may be reduced. The case of the insufficient supplied power may refer to a situation where power is provided under the above-described low voltage conditions (e.g., voltage of 3.7 V or lower).

When the linearity of the power amplifier (PA) 720 decreases, as illustrated in 760 of FIG. 7B, unecessary frequency components may be generated at the left and right of the center frequency (0 MHz in 760 of FIG. 7B). Unnecessary frequency components may interfere with an output signal. The unnecessary frequency components may prevent proper demodulation when demodulating the transmitted signal back to its original signal. The unnecessary frequency components illustrated in 760 of FIG. 7B may cause the degradation in the transmitted signal quality and/or the transmission failure.

The electronic device (e.g., the electronic device 600 of FIG. 6) according to the present document may address the voltage drop occurring in the satellite RF power amplifier (PA). The electronic device 600 may compare voltage levels at a PA PMIC output and a PA VCC terminal using a feedback line and at least one switch on a power supply of the power amplifier (PA) VCC, calculate the voltage drop level according to the voltage difference, and compensate for the power supply in a booster of the PA PMIC. Hereinafter, a process for calculating the voltage drop level in the electronic device 600 and performing the compensation equivalent to the voltage drop to resolve the voltage drop issue in the power amplifier (PA) will be described.

FIG. 8A illustrates a configuration for describing a switching operation of an electronic device according to an embodiment of the present document.

The electronic device (e.g., the electronic device 600 of FIG. 6) according to the present document may include a communication circuit (e.g., the communication circuit 630 of FIG. 6). The communication circuit 630 may include a battery 801, an IF PMIC 803, a first PA PMIC 811, a second PA PMIC 812, a first switch 821, a second switch 822, a power amplifier (PA) 830, an RF switch 832, a plurality of antennas 841, 842, and 842 responsible for cellular communication, and at least one antenna 845 responsible for satellite communication. The electronic device 600 may include an RFIC (e.g., an RFIC 716 of FIG. 7) and a modem (e.g., a modem 714 of FIG. 7) for communication.

The electronic device 600 may apply a voltage to the power amplifier 830 by using all of the multiple PA PMICs to satisfy a certain level (e.g., about 29 dBm) or more of effective isotropic radiated power (EIRP) required by a satellite communication system. The first PA PMIC 811 and the second PA PMIC 812 may supply power to the power amplifier (PA) 830. The first PA PMIC 811 and the second PA PMIC 812 are configured as a buck booster and may receive the information on the voltage drop from the communication processor (e.g., the communication processor 610 of FIG. 6) and compensate for the output.

The communication circuit 630 may boost an output of a satellite transmission signal transmitted from a transceiver (e.g., the transceiver 620 of FIG. 6) and transmit the the satellite transmission signal via an antenna 845. When using a satellite signal with a relatively high output within the circuit of the integrated terminal, even a small resistance change may cause a relatively large voltage drop in the power amplifier (PA) 830.

The communication processor 610 may determine the voltage drop level of the power amplifier (PA) 830 and compensate for the voltage using the first PA PMIC 811 and/or the second PA PMIC 812.

The electronic device 600 according to various embodiments of the present document may have a wiring for a wiring for feedback (feedback line) located on a node branched from a PA VCC wiring adjacent to the power amplifier (PA) 830. The feedback line may be connected to an output terminal of the first PA PMIC 811 via the first switch 821 and to an output terminal of the second PA PMIC 812 via the second switch 822.

In the situation where the cellular network is used, the electronic device 600 may identify the power level input to the power amplifier (PA) 830 via the feedback lines of the first PA PMIC 811 and/or the second PA PMIC 812, and adjust the output value of the first PA PMIC 811 and/or the second PA PMIC 812 based on the identified value. When the satellite network is used under specific conditions (e.g., low temperature, low voltage), the electronic device 600 may identify the voltage drop input to the power amplifier (PA) 830. The electronic device 600 may identify the voltage drop level and compensate for the voltage of the first PA PMIC 811 and/or the second PA PMIC 812 equivalent to the voltage drop.

When the electronic device 600 uses a satellite network under the specific conditions (e.g., low temperature, low voltage), the first switch 821 may be controlled to be connected to a first feedback line A and the second switch 822 may be controlled to be connected to a fourth feedback line D under the control of the communication processor 610. The first switch 821 may be connected to the first feedback line A branched at a point relatively close to the output terminal of the first PA PMIC 811 while being electrically connected to the first PA PMIC 811, and may be connected to the second feedback line B branched at a point relatively close to the power supplied to the power amplifier (PA) 830. The connection of the first switch 821 to the first feedback line A may refer to electrically connecting an output port of the first PA PMIC 811 to the first PA PMIC 811. The relatively close point may refer to a relatively close point between the output port of the first PA PMIC 811 and the power supplied to the power amplifier (PA) 830. The electronic device 600 may differently control the connection state of the first switch 821 under the control of the communication processor 610.

The electronic device 600 may detect the output voltage of the first PA PMIC 811 by controlling the first switch 821 to be connected to the first feedback line A. The electronic device 600 may detect the voltage supplied to the power amplifier (PA) 830 by controlling the second switch 822 to be connected to the fourth feedback line D. The connection of the second switch 822 to the fourth feedback line D may refer to the electrical connection of the second PA PMIC 812 to the input port of the power amplifier 830. This will be described in detail in FIG. 8B.

The electronic device 600 may compare the output voltage of the first PA PMIC 811 with the voltage supplied to the power amplifier (PA) 830 and determine the difference value. The electronic device 600 may compensate for (or adjust, change) the output voltage of the first PA PMIC 811 to compensate for the voltage equivalent to the difference. The compensated output voltage of the first PA PMIC 811 may be substantially the same as a value obtained by adding the output voltage before the compensation of the first PA PMIC 811 and the difference value. That is, the electronic device 600 may compensate for (or adjust, change) the output voltage of the first PA PMIC 811 so that the voltage supplied to the power amplifier 830 is not affected by the voltage drop (or the effect of the voltage drop is minimized), and may prevent the distortion of the signal amplified by the power amplifier 830 for occurring.

The second switch 822 may be connected to the third feedback line C branched at a point relatively close to the output terminal of the second PA PMIC 812 while being electrically connected to the second PA PMIC 812, and may be connected to the fourth feedback line D branched at a point relatively close to the power supplied to the power amplifier (PA) 830. The connection of the second switch 822 to the fourth feedback line D may refer to the electrical connection of the second PA PMIC 812 to the input port of the power amplifier 830. The relatively close point may refer to a relatively close point between the output terminal of the second PA PMIC 812 and the power supplied to the power amplifier (PA) 830. The electronic device 600 may differently control the connection state of the second switch 822 under the control of the communication processor 610.

The compensated output voltage of the second PA PMIC 812 may be substantially the same as a value obtained by adding the output voltage before the compensation of the second PA PMIC 812 and the difference value.

According to an embodiment, the electronic device 600 may detect the output voltage of the second PA PMIC 812 by controlling the second switch 822 to be connected to the third feedback line C. The electronic device 600 may detect the voltage supplied to the power amplifier (PA) 830 by controlling the first switch 821 to be connected to the third feedback line C.

The electronic device 600 may compare the output voltage of the second PA PMIC 812 with the voltage supplied to the power amplifier (PA) 830 and determine the difference. The electronic device 600 may compensate for the output voltage of the second PA PMIC 812 to compensate for the voltage equivalent to the difference. That is, the electronic device 600 may control the second PA PMIC 812 to compensate for the output voltage of the second PA PMIC 812 so that a voltage supplied to the power amplifier (PA) 830 is maintained at a constant level despite a voltage drop, thereby preventing signal distortion from occurring.

FIG. 8B illustrates a first embodiment of a switching operation of the electronic device according to an embodiment of the present document.

The electronic device 600 may detect the output voltage of the first PA PMIC 811 by controlling the first switch 821 to be connected to the first feedback line A. The electronic device 600 may detect the voltage supplied to the power amplifier (PA) 830 by controlling the second switch 822 to be connected to the fourth feedback line D.

The electronic device 600 may compare the output voltage of the first PA PMIC 811 with the voltage supplied to the power amplifier (PA) 830 and determine the difference. The electronic device 600 may compensate for the output voltage of the first PA PMIC 81 1 to compensate for the voltage equivalent to the difference. That is, the electronic device 600 may control the first PA PMIC 811 to compensate for the output voltage of the first PA PMIC 811 so that a voltage supplied to the power amplifier (PA) 830 is maintained at a constant level despite a voltage drop, thereby preventing signal distortion from occurring.

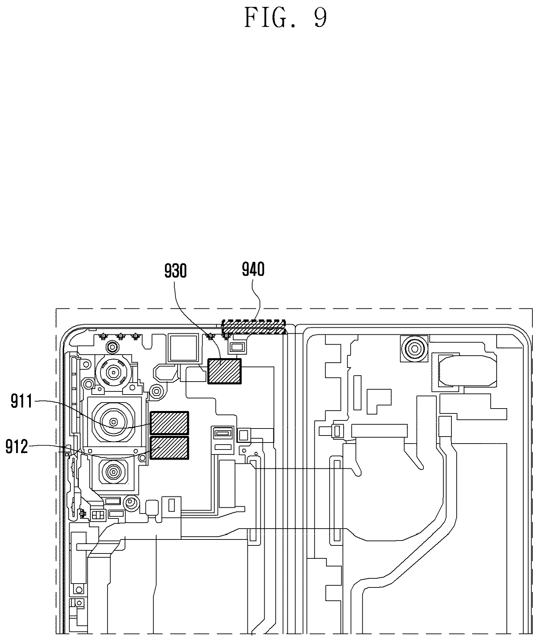

FIG. 9 illustrates locations of a PMIC and a satellite power amplifier (PA) on the electronic device according to an embodiment.

The electronic device (e.g., the electronic device 600 of FIG. 6) may generate a relatively high output (e.g., about 36 dBm) by simultaneously using multiple PA PMICs (the first PA PMIC 911 and the second PA PMIC 912) under the control of the communication processor (e.g., the communication processor 610 of FIG. 6).

The electronic device 600 may supply a relatively high output (e.g, about 36 dBm) to a power amplifier (PA) 930 (e.g., the power amplifier (PA) 830 of FIG. 8).

As illustrated in FIG. 8A, the electronic device 600 may control the Vcc of the power amplifier (PA) 930 using the feedback lines of the first PA PMIC 911 and the second PA PMIC 912 in the situation where the cellular network is used. Since the voltage drop may occur in the power amplifier (PA) 930 when using the satellite network under the specific conditions (e.g., low temperature and low voltage), the electronic device 600 may detect the voltage drop in the power amplifier (PA) 930. The electronic device 600 may identify the voltage drop level and compensate for the voltage of the first PA PMIC 911 and/or the second PA PMIC 912 equivalent to the voltage drop.

That is, the electronic device 600 may control the first PA PMIC 911 and/or the second PA PMIC 912 to compensate for the voltage of the first PA PMIC 911 and/or the second PA PMIC 912 so that the voltage supplied to the power amplifier (PA) 930 is maintained at a constant level, thereby preventing the signal distortion from occurring. The electronic device 600 may transmit a signal without distortion to the satellite base station using the antenna 940.

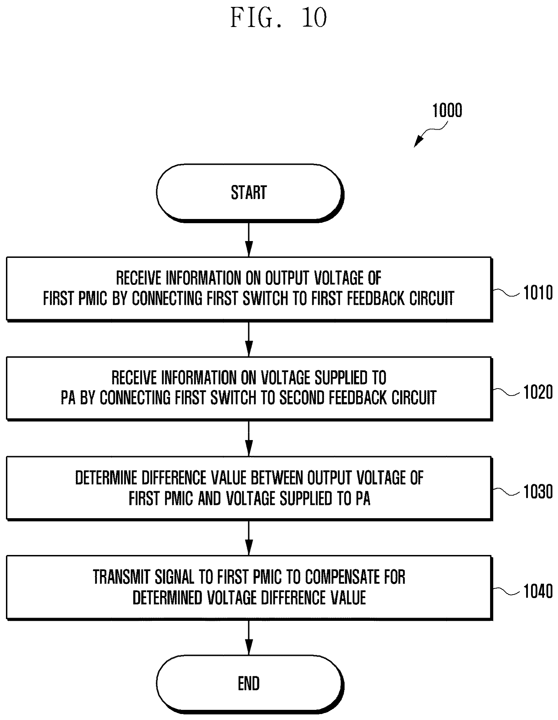

FIG. 10 is a flowchart illustrating an antenna switching operation of the electronic device according to an embodiment.

The operations described with reference to FIG. 10 may be implemented based on instructions that may be stored in a computer recording medium or memory (e.g., the memory 130 of FIG. 1). The method 1000 illustrated may be executed by the electronic device (e.g., electronic device 600 of FIG. 6) described above with reference to FIGS. 1 to 9, and the technical features described above will be omitted below. The order of each operation of FIG. 10 may be changed, some operations may be omitted, and some operations may be performed simultaneously.

In operation 1010, the electronic device (e.g., electronic device 600 of FIG. 6) may receive information on an output voltage of a first PA PMIC (e.g., the first PA PMIC 811 of FIG. 8A) by connecting a first switch (e.g., the first switch 821 of FIG. 8A) to a first feedback line (e.g., the first feedback line A of FIG. 8A) under the control of the communication processor (e.g., the communication processor 610 of FIG. 6). The electronic device 600 according to various embodiments of the present document may have a feedback line located on a node branched from a PA VCC wiring adjacent to the power amplifier (PA) 830. The feedback line may be connected to the output terminal of the first PA PMIC 811 via the first switch 821 and to the output terminal of the second PA PMIC 812 via the second switch (e.g., the second switch 822 of FIG. 8A).

In operation 1020, the communication processor 610 may receive the information on the voltage supplied to the PA (e.g., the power amplifier (PA) 830 of FIG. 8A) by connecting the first switch 811 to the second feedback line (e.g., the second feedback line B of FIG. 8A).

In operation 1030, the communication processor 610 may determine the difference value between the output voltage of the first PA PMIC 811 and the voltage supplied to the PA 830. The communication processor 610 may determine the difference value based on the information on the output voltage of the first PA PMIC 811 acquired in operation 1010 and the information on the supply voltage of the PA 830 acquired in operation 1020. The difference value may indicate a voltage drop value.

In operation 1040, the communication processor 610 may transmit a signal to the first PA PMIC 811 to compensate for the determined voltage difference value. The communication processor 610 may compensate for the voltage of the first PA PMIC 811 equivalent to the determined difference value. That is, the electronic device 600 may control the first PA PMIC 811 to compensate for the output voltage of the first PA PMIC 811 so that the voltage supplied to the PA 830 is maintained at a constant level despite the voltage drop, thereby preventing the signal distortion from occurring.

Although the process of determining the voltage drop and compensating for the voltage by comparing the output voltage of the first PA PMIC 811 with the voltage supplied to the PA 830 is described with reference to FIG. 10, the voltage drop may be determined and the voltage may be compensated by using the output voltage of the second PA PMIC 812. Alternatively, the first switch 821 and the second switch 822 may be controlled simultaneously to relatively quickly compare the output voltage of the PA PMIC with the voltage supplied to the PA 830 and compensate for the voltage.

The electronic device may include the power amplifier (PA) 830 amplifying the RF signal to be transmitted to the satellite base station, the first power amplifier power management integrated circuit (PA PMIC) 811 supplying power to the power amplifier (PA), the first switch 821 connecting one of the output port of the first PA PMIC and the input port of the PA to the first PA PMIC, and the communication processor 610, in which the communication processor may control the first switch to connect the output port of the first PA PMIC to the first PA PMIC, control the first PA PMIC to measure the output voltage of the first PA PMIC, control the first switch to connect the input port of the PA to the first PA PMIC, control the first PA PMIC to measure the supply voltage of the PA, determine the difference value between the output voltage of the first PA PMIC and the supply voltage of the PA, and adjust the output voltage of the first PA PMIC based on the determined difference value.

The electronic device may further include the second power amplifier power management integrated circuit (PA PMIC) 812 supplying the power to the power amplifier (PA) and the second switch 822 connecting one of an output port of the second PA PMIC and the input port of the PA to the second PA PMIC, in which the communication processor may control the first switch to connect the output port of the first PA PMIC to the first PA PMIC, control the first PA PMIC to measure the output voltage of the first PA PMIC, control the second switch to connect the input port of the PA to the second PA PMIC, control the second PA PMIC to measure the supply voltage of the PA, determine the difference value between the output voltage of the first PA PMIC and the supply voltage of the PA, and adjust the output voltage of the first PA PMIC based on the difference value.

The communication processor may control the second switch to connect the output port of the second PA PMIC to the second PA PMIC, control the second PA PMIC to measure an output voltage of the second PA PMIC, control the first switch to connect the input port of the PA to the first PA PMIC, control the first PA PMIC to measure the supply voltage of the PA, determine a difference voltage between the supply voltage of the PA and an output voltage of the second PA PMIC, and adjust the output voltage of the second PA PMIC based on the difference value.

The electronic device may further include the second power amplifier power management integrated circuit (PA PMIC) 812 supplying the power to the power amplifier (PA), and the second switch 822 connecting one of an output port of the second PA PMIC and the input port of the PA to the second PA PMIC, in which the communication processor may control the second switch to connect an output port of the second PA PMIC to the second PA PMIC, control the second PA PMIC to measure an output voltage of the second PA PMIC, control the second switch to connect the input port of the PA to the second PA PMIC, control the second PA PMIC to measure the supply voltage of the PA, determine a difference value between an output voltage of the second PA PMIC and the supply voltage of the PA, and adjust the output voltage of the second PA PMIC based on the difference value..

The first switch may be connected to the first feedback line branched at the point relatively close to the output terminal of the first PA PMIC while being electrically connected to the first PA PMIC, and may be connected to the second feedback line branched at the point relatively close to the power supplied to the PA.

The relatively close point may refer to the relatively close point between the output terminal of the first PA PMIC and the power supplied to the PA.

The communication processor may transmit the signal output from the PA to the satellite base station via the antenna

The second switch may be connected to the third feedback line branched at the point relatively close to the output terminal of the second PA PMIC while being electrically connected to the second PA PMIC, and may be connected to the fourth feedback line branched at the point relatively close to the power supplied to the PA.

The relatively close point may refer to the relatively close point between the output terminal of the second PA PMIC and the power supplied to the PA.

The method for operating an electronic device may include controlling the first switch to connect the output port of a first PA PMIC to the first PA PMIC, controlling the first PA PMIC to measure the output voltage of the first PA PMIC, controlling the first switch to connect the input port of the PA to the first PA PMIC, controlling the first PA PMIC to measure the supply voltage of the PA, determining the difference value between the output voltage of the first PA PMIC and the supply voltage of the PA, and adjusting the output voltage of the first PA PMIC based on the determined difference value.

## Claims

1. An electronic device (101), comprising:
a power amplifier (PA) (830) amplifying a RF signal to be transmitted to a satellite base station;
a first power amplifier power management integrated circuit (PA PMIC) (811) supplying power to the power amplifier (PA);
a first switch (821) connecting one of an output port of the first PA PMIC and an input port of the PA to the first PA PMIC; and
a communication processor (610),
wherein the communication processor is configured to control the first switch to connect the output port of the first PA PMIC to the first PA PMIC and control the first PA PMIC to measure an output voltage of the first PA PMIC,
control the first switch to connect the input port of the PA to the first PA PMIC and control the first PA PMIC to measure a supply voltage of the PA,
determine a difference value between the output voltage of the first PA PMIC and the supply voltage of the PA, and
adjust the output voltage of the first PA PMIC based on the determined difference value.

2. The electronic device of claim 1, further comprising:
a second power amplifier power management integrated circuit (PA PMIC) (812) supplying the power to the power amplifier (PA); and
a second switch (822) connecting one of an output port of the second PA PMIC and the input port of the PA to the second PA PMIC,
wherein the communication processor is configured to control the first switch to connect the output port of the first PA PMIC to the first PA PMIC and control the first PA PMIC to measure an output voltage of the first PA PMIC,
control the second switch to connect the input port of the PA to the second PA PMIC and control the second PA PMIC to measure the supply voltage of the PA,
determine a difference value between the output voltage of the first PA PMIC and the supply voltage of the PA, and
adjust the output voltage of the first PA PMIC based on the difference value.

3. The electronic device of claim 2, wherein the communication processor is configured to control the second switch to connect the output port of the second PA PMIC to the second PA PMIC and control the second PA PMIC to measure an output voltage of the second PA PMIC,
control the first switch to connect the input port of the PA to the first PA PMIC and control the first PA PMIC to measure the supply voltage of the PA,
determine a difference voltage between the supply voltage of the PA and an output voltage of the second PA PMIC, and
adjust the output voltage of the second PA PMIC based on the difference value.

4. The electronic device of claim 1, further comprising:
a second power amplifier power management integrated circuit (PA PMIC) (812) supplying the power to the power amplifier (PA); and
a second switch (822) connecting one of an output port of the second PA PMIC and the input port of the PA to the second PA PMIC,
wherein the communication processor is configured to control the second switch to connect an output port of the second PA PMIC to the second PA PMIC and control the second PA PMIC to measure an output voltage of the second PA PMIC,
control the second switch to connect the input port of the PA to the second PA PMIC and control the second PA PMIC to measure the supply voltage of the PA,
determine a difference value between an output voltage of the second PA PMIC and the supply voltage of the PA, and
adjust the output voltage of the second PA PMIC based on the difference value.

5. The electronic device of claim 1, wherein the first switch is connected to a first feedback line branched at a point relatively close to an output terminal of the first PA PMIC while being electrically connected to the first PA PMIC, and is connected to a second feedback line branched at a point relatively close to the power supplied to the PA.

6. The electronic device of claim 5, wherein the relatively close point refers to relatively close point between the output terminal of the first PA PMIC and the power supplied to the PA.

7. The electronic device of claim 1, wherein the communication processor transmits a signal output from the PA to the satellite base station via an antenna.

8. The electronic device of claim 2, wherein the second switch is connected to a third feedback line branched at a point relatively close to an output terminal of the second PA PMIC while being electrically connected to the second PA PMIC, and is connected to a fourth feedback line branched at a point relatively close to the power supplied to the PA.

9. The electronic device of claim 8, wherein the relatively close point refers to relatively close point between the output terminal of the second PA PMIC and the power supplied to the PA.

10. A method for operating an electronic device, comprising:
controlling a first switch to connect an output port of a first PA PMIC and the first PA PMIC and controlling the first PA PMIC to measure the output voltage of the first PA PMIC;
controlling the first switch to connect an input port of the PA to the first PA PMIC and controlling the first PA PMIC to measure a supply voltage of the PA;
determining a difference value between the output voltage of the first PA PMIC and the supply voltage of the PA; and
adjusting the output voltage of the first PA PMIC based on the determined difference value.

11. The method of claim 10, further comprising:
controlling a first switch to connect an output port of a first PA PMIC to the first PA PMIC and controlling the first PA PMIC to measure the output voltage of the first PA PMIC;
controlling the second switch to connect an input port of the PA to a second PA PMIC and controlling the second PA PMIC to measure the supply voltage of the PA;
determining a difference value between the output voltage of the first PA PMIC and the supply voltage of the PA; and
adjusting the output voltage of the first PA PMIC based on the difference value.

12. The method of claim 11, further comprising:
controlling the second switch to connect the output port of the second PA PMIC to the second PA PMIC and controlling the second PA PMIC to measure the output voltage of the second PA PMIC;
controlling the first switch to connect the input port of the PA to the first PA PMIC and controlling the first PA PMIC to measure the supply voltage of the PA;
determining a difference voltage between the supply voltage of the PA and an output voltage of the second PA PMIC; and
adjusting the output voltage of the second PA PMIC based on the difference value.

13. The method of claim 11, further comprising:
controlling the second switch to connect an output port of the second PA PMIC to the second PA PMIC and controlling the second PA PMIC to measure the output voltage of the second PA PMIC;
controlling the second switch to connect the input port of the PA to the second PA PMIC and controlling the second PA PMIC to measure the supply voltage of the PA;
determining a difference value between the output voltage of the second PA PMIC and the supply voltage of the PA; and
adjusting the output voltage of the second PA PMIC based on the difference value.

14. The method of claim 10, wherein the first switch is connected to a first feedback line branched at a point relatively close to an output terminal of the first PA PMIC while being electrically connected to the first PA PMIC, and is connected to a second feedback line branched at a point relatively close to the power supplied to the PA.

15. The method of claim 14, wherein the relatively close point refers to relatively close point between the output terminal of the first PA PMIC and a power supplied to the PA.
